Europäisches Patentamt

European Patent Office

Office européen des brevets

(11) Veröffentlichungsnummer: **0 026 807**
**B1**

(12) **EUROPÄISCHE PATENTSCHRIFT**

(45) Veröffentlichungstag der Patentschrift: **29.06.83**

(21) Anmeldenummer: **80102233.6**

(22) Anmeldetag: **25.04.80**

(51) Int. Cl.³: **H 05 K 1/14, H 01 L 23/52**

(54) **Mehrlagen-Modul mit konstantem Wellenwiderstand.**

(30) Priorität: **06.10.79 DE 2940593**

(43) Veröffentlichungstag der Anmeldung:
**15.04.81 Patentblatt 81/15**

(45) Bekanntmachung des Hinweises auf die Patenterteilung:
**29.06.83 Patentblatt 83/26**

(84) Benannte Vertragsstaaten:
**DE FR GB**

(56) Entgegenhaltungen:
**DE - A - 2 445 533**
**DE - A - 2 723 163**
**US - A - 3 798 762**

**IBM TECHNICAL DISCLOSURE BULLETIN, Band Nr. 8, Januar 1978 M. E. ECKER et al. "Semiconductor Package Structure" Seiten 3092 bis 3093**

(73) Patentinhaber: **International Business Machines Corporation**
**Armonk, N.Y. 10504 (US)**

(72) Erfinder: **Krumm, Horst, Dr.**
**Goldäckerstrasse 14**
**D-7031 Steinenbronn (DE)**
Erfinder: **Schettler, Helmut**
**Jägerstrasse 23**
**D-7405 Dettenhausen (DE)**
Erfinder: **Stahl, Rainer**
**Seestrasse 27**
**D-7036 Schönaich (DE)**
Erfinder: **Zühlke, Rainer, Dr.**
**Rainstrasse 3**
**D-7250 Leonberg 7 (DE)**

(74) Vertreter: **Blutke, Klaus, Dipl.-Ing.**
**Schönaicher Strasse 220**
**D-7030 Böblingen (DE)**

Mehrlagen-Modul mit konstantem Wellenwiderstand

Die Erfindung betrifft einen Mehrlagen-modul mit konstantem Wellenwiderstand. Üblicherweise sind solche Module aus mehreren Schichten von Keramikmaterial aufgebaut, zwischen denen die Leiterebenen verlaufen. Diese Leiter können sowohl Signalleitungen, geerdete oder an Masse gelegte Leitungen (im folgenden Masseleitungen genannt) oder Leitungen sein, welche mit einer Betriebsspannung beaufschlagt sind (im folgenden Spannungsversorgungsleitungen genannt). Anschlüsse zu den in verschiedenen Schichten verlaufenden Leitungen werden durch sogenannte Kontaktierungen durch eine oder mehrere Schichten hindurch hergestellt.

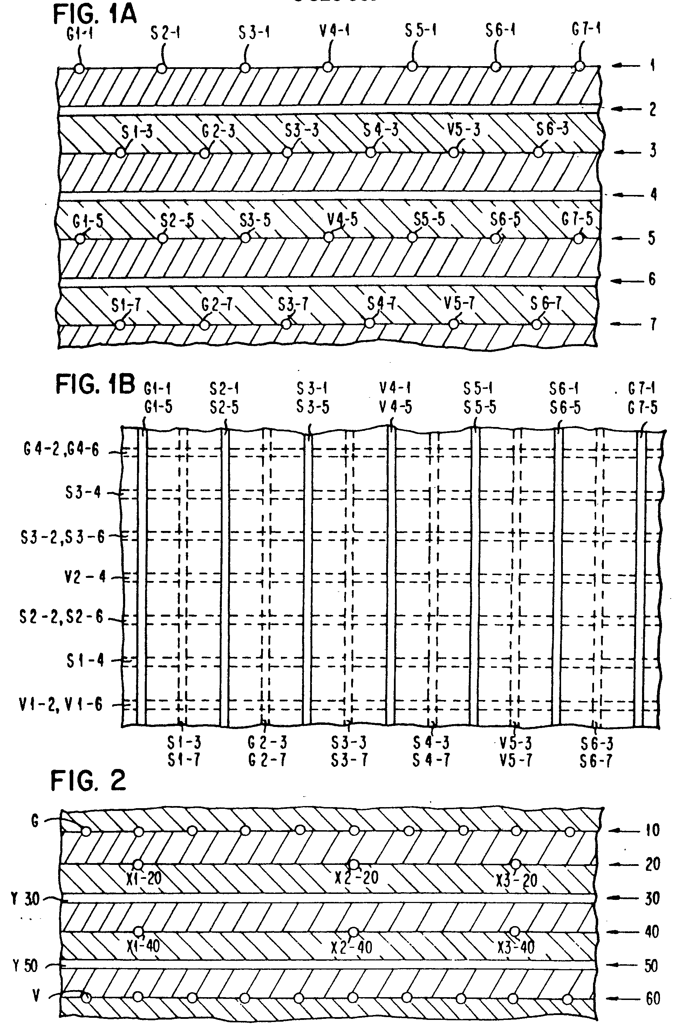

Wie in Fig. 2 beschrieben, sind Mehrlagenmodule bekannt, bei denen zwischen einer Ebene von Masseleitungen und einer Ebene von Spannungsversorgungsleitungen Signalleitungsebenen angeordnet sind. Zweckmäßigerweise verlaufen die Leiter zweier übereinanderliegender Signalleitungsebenen orthogonal zueinander, um eine gegenseitige Leitungsbeeinflussung zu minimieren. Anordnungen dieser Art werden z.B. in der auf dem Markt befindlichen Rechner Serie IBM 4300 benutzt.

Des weiteren ist aus dem IBM TDB Vol. 20, Nr. 8, S. 3092, 1978 eine Anordnung bekannt, bei der Spannungsversorgungs- und Signalleitungen in einer Ebene verlaufen. Zwischen zwei Spannungsversorgungsleitungen sind jeweils drei Signalleitungen eingeschlossen. Des weiteren ist in dieser Veröffentlichung darauf hingewiesen, daß bei Verwendung mehrerer Leitungsebenen eine diagonale Verschiebung zweier entsprechender Ebenen zueinander aus Gründen der Minimierung eines Gegenspracheffektes angebracht erscheint.

Die zuvor beschriebenen bekannten Anordungen weisen den Nachteil auf, daß sie für hohe Signalfolgen (schnellste Schaltzeiten elektronischer Bausteine) nicht einsetzbar sind. Der Grund hierfür liegt darin begründet, daß die Wellenwiderstände der einzelnen Signalleitungen unterschiedlich groß sind, so daß sich durch damit zwangsweise verbundene Fehlanpassungen zu den mit den Mehrlagenmodulen verbundenen Schaltkreisen verschieden starke Reflexionen ergeben, die sich auf eine schnelle optimale Signalübertragung störend auswirken bzw. eine solche Übertragung unmöglich machen.

Aus diesem Grunde ist es Aufgabe der Erfindung, einen Mehrlagenmodul mit konstantem Wellenwiderstand der Signalleitungen anzugeben.

Diese Aufgabe der Erfindung wird in vorteilhafter Weise durch die im kennzeichnenden Teil des Anspruches 1 angegebenen Maßnahmen gelöst.

Vorteilhafte Weiterbildungen der Erfindung sind den Unteransprüchen zu entnehmen.

Ein Ausführungsbeispiel der Erfindung ist in den Zeichnungen dargestellt und wird im folgenden näher beschrieben:

Es zeigen:
Fig. 1A eine schematische Schnittdarstellung durch einen Mehrlagenmodul mit konstantem Wellenwiderstand,
Fig. 1B eine Aufsicht auf einen Mehrlagenmodul gemäß Fig. 1,
Fig. 2 eine schematische Schnittdarstellung eines Mehrlagenkeramikmoduls nach dem Stand der Technik,
Fig. 3 eine perspektivische Hilfdarstellung zum Leiterverlauf in 4 Ebenen.

In Fig. 1 ist ein Mehrlagen-Keramikmodul mit konstantem Wellenwiderstand in Schnittdarstellung gezeigt. Die Leiter in den einzelnen Ebenen verlaufen jeweils orthogonal zueinander. Die Leiterebenen sind mit 1 bis 7 gekennzeichnet. Es sei angenommen, daß alle Leiter den gleichen Querschnitt aufweisen und die Leiter in den Ebenen äquidistant zueinander angeordnet sind. Die Masseleitungen sind mit G, die Signalleitungen mit S und die Spannungsversorgungsleitungen mit V gekennzeichnet. In einer Ebene sind jeweils zwei nebeneinanderliegende Signalleitungen zwischen einer Masseleitung und einer Spannungsversorgungsleitung eingeschlossen. In der Ebene 1 folgen somit auf die Masseleitung G1-1 die Signalleitungen S2-1 und S3-1, die Spannungsversorgungsleitung V4-1, die Signalleitungen S5-1 und S6-1 und die Masseleitung G7-1. In der unter der ersten Leitungsebene liegenden zweiten Leitungsebene folgen, wie aus Fig. 1B hervorgeht, die Leitungen in folgender Reihenfolge: Spannungsversorgungsleitung V1-2, Signalleitung S2-2, Signalleitung S3-2 und Masseleitung G4-2. Die Leitungen der ersten und zweiten Ebene verlaufen jeweils orthogonal zueinander. Die Leitungen in der dritten Leitungsebene 3 verlaufen parallel zu denen in der ersten Ebene 1. Jedoch sind die Leitungen der dritten Ebene gegenüber denen in der ersten Ebene jeweils um eine halbe Abstandsbreite der Leitungen versetzt. Auf diese Weise liegt in entsprechender horizontaler Projektion die Signalleitung S1-3 der dritten Ebene zwischen den Leitungen G1-1 und S2-1 der ersten Ebene. Die auf die Leitung S1-3 folgende Leitung, die Masseleitung G2-3, liegt in horizontaler Projektion zwischen den Signalleitungen S2-1 und S3-1 der ersten Ebene usw.

In der dritten Signalebene folgen die Leitungen wie angegeben (Fig. A) aufeinander: Signalleitung S1-3, Masseleitung G2-3, Signalleitung S3-3, Signalleitung S4-3, Spannungsversorgungsleitung V5-3, Signalleitung S6-3.

Die in der vierten Ebene verlaufenden Leitungen zeigen eine Folge, die aus Fig. 1B hervorgeht:

S1-4, V2-4, S3-4.

Diese Leitungen sind gegenüber denen in der Ebene 2 um die halbe Abstandsbreite der Leitungen versetzt.

Die Leitungen in der fünften Ebene:

G1-5, S2-5, S3-5, V4-5, S5-5, S6-5 und G7-5,

sind in ihrem Verlauf auf die Leitungen in der ersten Ebene G1-1 bis G7-1 ausgerichtet, während die Leitungen in der siebenten Ebene S1-7, G2-7, S3-7, S4-7, V5-7 und S6-7 wieder um eine halbe Abstandsbreite der Leitungen gegenüber den Leitungen in der fünften Ebene versetzt sind. Die in der sechsten Ebene verlaufenden Leitungen V1-6, S2-6, S3-6 und G4-6 verlaufen analog zu dem bisher Gesagten unter den Leitungen der zweiten Ebene.

Durch diese gegenseitige Anordnung der Leitungen, durch das Einschließen zweier Signalleitungen zwischen einer Masseleitung und einer Spannungsversorgungsleitung sowie durch das Versetzen der Leitungen in zwei korrespondierenden Leitungsebenen (z.B. Ebene 1/Ebene 3 oder Ebene 3/Ebene 5 oder Ebene 5/Ebene 7) um einen halben Leitungsabstand ergibt sich eine gleichbleibende symmetrische Ausrichtung der Signalleitungen zu den Masse- bzw. Spannungsversorgungsleitungen, wodurch ein konstanter Wellenwiderstand der Signalleitungen begründet wird.

Der konstante Wellenwiderstand, der an den der an die Mehrlagenmodule anzuschließenden elektronischen Schaltkreise angepaßt ist, verhinder störende Reflexionen. D.h., die vorbeschriebene Anordnung kann für sehr hohe Signalfolgen, d.h. für Schaltkreise kürzester Schaltzeiten Verwendung finden.

In Fig. 2 ist eine Anordnung gezeigt, wie sie bereits bekannt ist. In dieser Schnittdarstellung eines Mehrlagenmoduls sind zwischen einer Masseleitungsebene 10 und einer Spannungsversorgungsleitungsebene 60 (die einzelnene Masseleitung sind mit G, die einzelnen Spannungsversorgungsleitungen mit V gekennzeichnet) die Signalleitungsebenen 20, 30, 40 und 50 eingeschlossen. Die Leitungen der Ebenen 30 und 50 verlaufen orthogonal zu denen in den Ebenen 20 und 40. Die Signalleitungen der Ebene 20 sind mit X1-20, X2-20 und X3-20, die in der Ebene 40 mit X1-40, X2-40 und X3-40, die in der Ebene 30 mit Y-30 und die in der Ebene 50 mit Y-50 gekennzeichnet. Bei dieser Anordnung ergeben sich keine gleichbleibenden Symmetrien der Signalleitungen zu den Masse- und Spannungsversorgungsleitungen. Dadurch ist auch der Wellenwiderstand der einzelnen Signalleitungen nicht konstant. Aus diesem Grunde kann eine solche Anordnung für kürzeste Schaltzeiten nicht eingesetzt werden.

Wenn auch das Ausführungsbeispiel nach Figur 1 auf einen äquidistanten Abstand der Leitungen in den einzelnen Ebenen abgestellt ist, so bedeutet dies nicht, daß ein ungleicher Leitungsabstand nicht möglich sein sollte. Es sind Konfigurationen denkbar, bei denen nebeneinanderliegende Signalleitungen einen größeren Abstand voneinander haben als der Abstand zwischen einer dieser Signalleitungen zu der ihr benachbarten Masse- bzw. Spannungsversorgungsleitung. Bei dieser Konfiguration ist wesentlich, daß der Abstand einer Signalleitung zu ihrer benachbarten Masse- bzw. Spannungsversorgungsleitung immer der gleiche ist.

Hinsichtlich der Symmetriebetrachtungen der Leitungen in einer Ebene und der Leitungen unterschiedlicher Ebenen ist folgendes zu bemerken: Zwischen einer Signalleitung und ihrer benachbarten Masse- bzw. Spannungsversorgungsleitung besteht eine Kopplung. Diese Kopplung kann sowohl zwischen den Leitungen innerhalb einer Ebene als auch zwischen den Leitungen der n-ten und (n+2)-ten Leitungsebene, z.B. zwischen S2-1 und G2-3 bestehen. Für die Übertragungscharakteristik ist jeweils die größere Kopplung maßgebend. Angenommen, die größere Kopplung würde zwischen den Leitungen innerhalb einer Ebene auftrete, so ist in diesem Fall die Betrachtung auf folgende Symmetrieverhältnisse abzustellen: Zwischen der Signalleitung, z.B. S3-5 der fünften Ebene und ihrer Nachbarspannungsversorgungsleitung V4-5 soll der gleiche Abstand auftreten, wie zwischen der Signalleitung S2-5 und ihrer Nachbarmasseleitung G1-5.

Eine andere Symmetriebetrachtung ist dann anzustellen, wenn die Kopplung zwischen den Leitungen der n-ten und (n+2)-ten Ebene größer und somit maßgebend ist als die Kopplung zwischen den Leitungen innerhalb einer Ebene. Mit anderen Worten (Fig. 1A): Der Abstand z.B. der Signalleitungen S2-5 und S3-5 der fünften Ebene zu der Masseleitung G2-3 in der dritten Ebene soll gleich sein, um eine Symmetrie dieser Signalleitungen zu der Masseleitung G2-3 zu bedingen. Eine solche Symmetrie ist für den Wellenwiderstand maßgebend. In speziellen Fällen ist es möglich, die Symmetriebetrachtungen sowohl auf die Leitungen innerhalb einer Ebene als auch auf die Leitungen in der n-ten und (n+2)-ten Eben auszudehnen. Dieser Spezialfall würde dann eintreten, wenn die Kopplungen der Leitungen innerhalb einer Ebene und der Leitungen in den oben erwähnten unterschiedlichen Ebenen gleich groß sind. Für diesen Spezialfall sollte der Abstand der einzelnen Leitungsebenen so gewählt werden, daß z.B. der Abstand zwischen der Signalleitung S3-5 zu ihrer Nachbarspannungsversorgungsleitung V4-5 der gleiche ist, wie der Abstand der Signalleitung S3-3 zu der Spannungsversorgungsleitung V4-5.

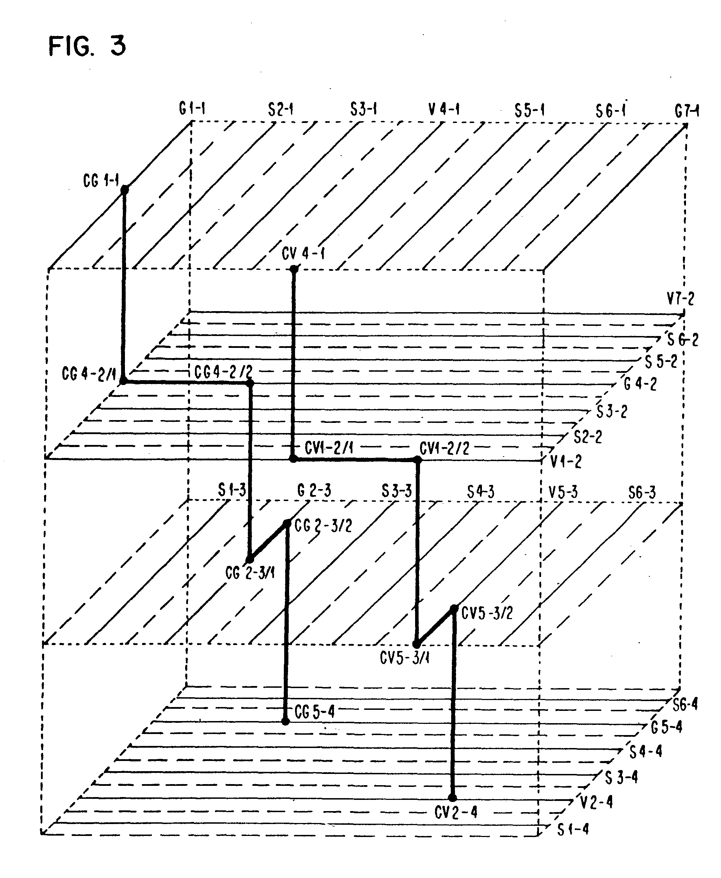

Die folgenden Betrachtungen beziehen sich auf das Durchkontaktieren der Leiterebenen. Beim Auftreten eines Signalstromes in einer Signalleitung (egal, ob innerhalb einer Ebene oder innerhalb verschiedener Ebenen, deren Signalleitungen entsprechend miteinander verbunden—durchkontaktiert—sind), ist es für eine gute Übertragungscharackteristik erforderlich, daß die Rückführung dieses Signalstromes in großer Nähe des Signalleitungsverlaufes über eine Masse- bzw. Spannungsversorgungsleitung (bei hochfrequenzmäßiger Betrachtung) erfolgt. Angenommen, die maßgebende Kopplung einer Signalleitung in der n-ten Ebene würde zu einer Masseleitung der (n+2)-ten Ebene bestehen. Um schaltungstechnisch zu gewährleisten, daß der Signalstrom auch den Rückweg durch die eben erwähnte Masseleitung nimmt, werden bestimmte Kontaktierungsmaßnahmen getroffen. Wie aus Fig. 1B in Zusammenhang mit Fig. 1A zu ersehen ist, können die Spannungsversorgungsleitungen bzw. die Masseleitungen der einzelnen Ebenen in der aus Fig. 3 ersichtlichen Weise durchkontaktiert werden. Diese Durchkontaktierung unterliegt folgendem Prinzip: die Masseleitung der n-ten Ebene wird mit der Masseleitung der (n+1)-ten Ebene durchkontaktiert, Analoges gilt für die Spannungsversorgungsleitungen etc. Die weitere Durchkontaktierung zur Masseleitung der dritten Ebene G2-3 muß versetzt von der ersten Durchkontaktierung vorgenommen werden. Diese Versetzung kann beiderseits des Kontaktierungspunktes erfolgen, der aus der Kontaktierung einer entsprechenden Leitung der n-ten mit der (n+1)-ten Ebene resultiert. Unbelagte Masseleitungen können mit Messe verbünden sein. Beispiel:

In Fig. 3 sind zur Darstellung der Kontaktierungsverbindungen vier Leitungsebenen perspektivisch schematisch dargestellt. In der ersten Ebene liegen die Leitungen G1-1, S2-1, S3-1, V4-1, S5-1, S6-1, G7-1; in der zweiten Ebene die Leitungen V1-2, S2-2, S3-2, G4-2, S5-2, S6-2, V7-2; in der dritten Ebene die Leitungen S1-3, G2-3, S3-3, S4-3, V5-3, S6-3 und in der vierten Ebene die Leitungen S1-4, V2-4, S3-4, S4-4, G5-4, S6-4. Die Masseleitungen sind wieder durch den Buchstaben G, die Signalleitungen durch den Buchstaben S und die Spannungsversorgungsleitungen durch den Buchstaben V gekennzeichnet. Die Leitungen der ersten (oben) und dritten Ebene bzw. der zweiten und vierten Ebene sind um halbe Leitungsabstände zueinander versetzt. Um die Darstellung anschaulicher und übersichtlicher zu gestalten, sind in allen Ebenen zusätzlich gestrichelte Linien als Rastermaß für den halben Leitungsabstand eingezeichnet. Die Kontaktierungsverbindungen sind stärker ausgezogen als die eigentlichen Leitungen; die Kontaktierungspunkte sind durch kleine Kreise schematisch angedeutet. Die Masseleitung G1-1 der ersten Ebene wird zur Masseleitung G4-2 der zweiten Ebene an den Punkten CG1-1 und CG4-2/1 durchkontaktiert. Die Masseleitung G4-2 der zweiten Eben erhält ihre Durchkontaktierung im Punkt CG4-2/2 zur Masseleitung G2-3 der dritten Ebene zum Punkt CG2-3/1. Diese Masseleitung G2-3 wiederum ist im Punkt CG2-3/2 mit der Masseleitung G5-4 der vierten Ebene im Punkt CG5-4 verbunden. Analog dazu erfolgt die Durchkontaktierung der Spannungsversorgungsleitung V4-1 mit V1-2, V5-3 und V2-4 über die Kontaktierungspunkte CV4-1, CV1-2/1, CV1-2/2, CV5-3/1, CV5-3/2 und CV2-4.

Als Beispiel, daß der vertikale Versatz der Kontaktierungsverbindungen jeweils zwei Möglichkeiten gibt, sei auf dem Punkt CV1-2/1 verwiesen. Gemäß Fig. 3 liegt der Kontaktierungspunkt CV1-2/2 rechts des erstgenannten Punktes CV1-2/1. Er könnte aber ebensogut auch links dieses Punktes gewählt werden.

Durch diese Art der Kontaktierung, welche an allen Kreuzungspunkten entsprechender Masse- bzw. Spannungsversorgungsleitungen zwei benachbarter Ebenen vorgenommen werden kann, ergibt sich eine relativ engmachige Struktur. Sie gewährleistet, daß die Rückführung eines Signalstromes in großer Nähe einer entsprechend aktivierten Signalleitung auftritt. Da die für die Signalleitung maßgebende Induktivität durch das Flächenintegral zwischen der Signal- und Rückführungsleitung bestimmt wird und die Rückführungsleitung in großer Nähe der Signalleitung verläuft, ergeben sich kleine Induktivitätswerte, was für die Signalübertragung nur vorteilhaft ist.

## Patentansprüche

1. Mehrlagen-Modul mit mehreren Ebenen jeweils parallel zueinander verlaufender Leitungen, wobei die Leitungen übereinanderliegender Ebenen orthogonal zueinander ausgerichtet sind, dadurch gekennzeichnet, daß in einer Leitungsebene (1, 2, 3, 4, 5, 6, 7) jeweils zwei Signalleitungen (S2-1, S3-1) zwischen einer Masse- (G1-1) und einer Spannungsversorgungsleitung (V4-1) angeordnet sind, daß sich diese Leitungsfolge Masse-/Signal-/Signal-/Spannungsversorgungsleitung in einer Leitungsebene mehrfach wiederholt, und daß der Abstand der Signalleitung zu ihrere Nachbarmasse- bzw. Spannungsversorgungsleitung jeweils gleich ist.

2. Mehrlagen-Modul mit mehreren Ebenen jeweils parallel zueinander verlaufender Leiter, wobei in übereinanderliegenden Ebenen die Leitungen orthogonal zueinander ausgerichtet sind, dadurch gekennzeichnet, daß in einer Ebene (1, 2, 3, 4, 5, 6, 7) jeweils zwei Signalleitungen (S2-1, S3-1) zwischen einer Masse (G1-1) und einer Spannungsversorgungsleitung (V4-1) angeordnet sind, daß sich diese Leitungsfolge Masse-/Signal-/Signal-/Spannungsversorgungsleitung in einer Ebene mehrfach wiederholt, daß die Leitungen der n-ten und (n+2)-ten Ebene jeweils so zueinander versetzt sind, daß in Projektion der n-ten auf die (n+2)-ten Ebene die Masseleitung der (n+2)-ten Ebene in die Mitte zwischen die beiden signalleitungen der n-ten Ebene zu liegen kommt.

3. Anordnung nach Anspruch 1 oder 2, dadurch gekennzeichnet, daß der Abstand der Leitungen innerhalb einer Ebene äquidistant ist.

4. Anordnung nach Anspruch 2, dadurch gekennzeichnet, daß eine Durchkontaktierung zwischen zwei übereinanderliegenden Ebenen an allen gedachten Kreuzungspunkten der Masse bzw. Spannungsversorgungsleitungen in beiden Ebenen erfolgt.

5. Anordnung nach Anspruch 2, dadurch gekennzeichnet, daß unbelegte Signalleitungen mit Masse verbunden sind.

6. Anordnung nach Anspruch 2, dadurch gekennzeichnet, daß der Abstand der Leitungsebenen so groß gewählt wird, daß der Abstand der Leitungen innerhalb einer Ebene dem Abstand der Signalleitung einer Ebene zu der ihr zugeordneten Masseleitung der anderen Ebene entspricht.

**Revendications**

1. Module multicouches avec plusieurs plans, les conducteurs d'un plan étant disposés en parallèle les uns par rapport aux autres, les conducteurs de plans superposés étant orientés orthogonalement les uns par rapport aux autres, caractérisé par le fait que dans chaque plan de conducteurs (1, 2, 3, 4, 5, 6, 7), deux lignes de signaux (S2-1, S3-1) sont disposés entre un conducteur de masse (G1-1) et un conducteur d'alimentation en tension (V4-1), que cette séquence de conducteurs masse/signal/signal/alimentation en tension se répète plusieurs fois dans un plan de conducteurs, et que la distance séparant la ligne de signal de son conducteur de masse ou d'alimentation en tension voisin, est toujours égale à zéro.

2. Module multicouches avec plusieurs plans, les conducteurs d'un plan étant disposés en parallèle les uns par rapport aux autres, les conducteurs de plans superposés étant orientés orthogonalement les uns par rapport aux autres, caractérisé par le fait que dans un plan (1, 2, 3, 4, 5, 6, 7), deux lignes de signaux (S2-1, S3-1) sont disposées, respectivement, entre un conducteur de masse (G1-1) et un conducteur d'alimentation en tension (V4-1), que cette séquence de conducteurs masse/signal/signal/alimentation en tension se répète plusieurs fois dans un plan, que les conducteurs du $n^{i\text{ème}}$ et (n+2)$^{i\text{ème}}$ plan sont toujours décalés les uns par rapport aux autres de telle sorte que, en projection du $n^{i\text{ème}}$ sur le

(n+2)$^{i\text{ème}}$ plan, le conducteur de masse du (n+2)$^{i\text{ème}}$ plan viendra se placer au centre, entre les deux lignes de signal du $n^{i\text{ème}}$ plan.

3. Module selon l'une des revendications 1 ou 2, caractérisé par le fait que l'espacement des conducteurs à l'intérieur d'un plan est toujours le même.

4. Module selon la revendication 2, caractérisé par le fait qu'il est prévu, entre deux plans superposés des trous de connexion, à tous les points d'intersection supposés des conducteurs de masse et d'alimentation en tension dans les deux plans.

5. Module selon la revendication 2, caractérisé par le fait que toutes les lignes de signal non utilisées sont reliées à la masse.

6. Module selon la revendication 2, caractérisé par le fait que l'espacement des plans de conducteurs est choisi de telle sorte que l'espacement des conducteurs à l'intérieur d'un plan corresponde à la distance séparant la ligne de signal d'un plan à son conducteur de masse associé de l'autre plan.

**Claims**

1. A multi-layer module with several planes, whose conductor lines extend parallel to each other, conductor lines of superposed planes being orthogonally aligned to each other, characterized in that in each conductor line plane (1, 2, 3, 4, 5, 6, 7) two signal lines (S2-1, S3-1) are arranged between a ground line (G1-1) and a voltage supply line (V4-1), that this conductor line sequence mass/signal/signal/voltage supply line in a conductor line plane is repeated several times, and that the spacing between the signal line and its adjacent ground and voltage supply line, respectively, is identical in each case.

2. A multi-layer module with several planes, whose conductor lines extend parallel to each other, conductor lines of superposed planes being orthogonally aligned to each other, characterized in that in each plane (1, 2, 3, 4, 5, 6, 7) two signal lines (S2-1, S3-1) are arranged between a ground line (G1-1) and a voltage supply line (V4-1), that this conductor line sequence ground/signal/signal/voltage supply line in a plane is repeated several times, that the conductor lines of the nth and the (n+2)th plane are staggered with respect to each other in such a manner that when the nth plane is projected relative to the (n+2)th plane, the ground line of the (n+2)th plane is arranged in the center between the two signal lines of the nth plane.

3. A structure according to claim 1 or 2, characterized in that the conductor lines in each planes are spaced equidistantly from each other.

4. A structure according to claim 2, characterized in that there are through connections between two superposed planes at all assumed crossings of the ground and the voltage supply lines, respectively, in both planes.

5. A structure according to claim 2, characterized in that unused signal lines are connected to ground.

6. A structure according to claim 2, characterized in that the spacing between conductor line planes is such that the spacing of conductor lines in one plane corresponds to the spacing between the signal line in one plane and its associated ground line in another.

FIG. 1A

FIG. 1B

FIG. 2

FIG. 3